# EUROPEAN PATENT SPECIFICATION

(11) **EP 2 405 054 B1**
(45) Date of publication and mention of the grant of the patent: **20.02.2013**
(21) Application number: 10168663.2
(22) Date of filing: 07.07.2010
(51) Int. Cl.: D06F 93/00

(54) **Textile item identification tag**
Identifizierungszeichen für ein Textilelement
Étiquette d'identification d'article textile

(43) Date of publication of application: 11.01.2012
(73) Proprietor: Datamars SA, 6930 Bedano-Lugano (CH)
(72) Inventor: Pachoud, Damien, 6963 Pregassona (CH); Stegmaier, Peter, Dr., 6946 Ponte Capriasca (CH)
(74) Representative: Harmann, Bernd-Günther

(56) References cited:
- DE-A1-102007 022 865
- DE-U1- 9 308 632
- US-A1- 2005 183 990
- US-B2- 7 247 214

## Description

The present invention relates generally to a textile item identification tag for RFID identification according to claim 1, and to a method of producing a textile item identification tag according to claim 15.

Radio Frequency Identification (RFID) transponders have found widespread use in a variety of applications. As the name RFID suggests, the basic idea is the identification of the goods, which can be done from a distance by wireless radio means by reading a code which is stored on the attached RFID transponder. Such transponders found lots of different fields of usage which even go beyond those basics, for example also things like
- identification of goods,
- storage and readout of information for counting, accounting, marking, etc.
- encryption or ciphering of information as for access control, security or validation purposes,
- wireless sensor applications or even
- complex microcontroller applications for lots of other purposes.

The word transponder, short for transmitter-responder, is used to describe a device which is capable of transmitting a reply signal in response to a received signal, wherein a signal is embodied as some kind of modulation of an energy source which can comprise information.

As the name implies, RFID transponders comprise at least one electromagnetic antenna or aerial for receiving and/or transmitting alternating electromagnetic radio-fields. In the present application, the reference to an electromagnetic field does also comprise fields where either the electrical or the magnetic part of the field is dominating, often referred to as magnetic-fields or electric-fields only.

There are different embodiments of such antennas known, which can be designed in many different shapes and sizes to fit the desired form factor and purpose (spectral characteristics, antenna gain, directional characteristics, etc.), for example by dedicated computer programs. For RFID-purposes, an aerial of a design which is suitable to be integrated into the desired form factor of the RFID transponder device is chosen, in particular patch- or microstrip-antennas, loop- or loopstick-antennas, frame-, folded- or spiral-dipole-antennas for rather flat RFID-transponders, or ferrite-antennas for rather pill- or bean-shaped designs are often used examples.

RFID Transponders working in the HF-Band are predominantly coupled by magnetic fields with relatively short ranges, mostly below one meter, and achieve good results with coil-like antennas for picking up the magnetic part of the radio field. Transponders in the UHF- or SHF-Band allow a longer range coupling of electromagnetic dipole fields.

In passive RFID transponders, the antenna is electronically coupled to an integrated circuit, which does not have a power supply such as a battery, but is energized by the electrical radio-energy picked up by the antenna. In response to the received energy, which can for example be stored by a small capacitor, the transponder generates a response signal which is retransmitted (usually by load modulation in HF and by backscattering in UHF) to and through the antenna to a nearby RFID-reader which often also transmits the energizing electromagnetic field. The field transmitted by the reader can also comprise data-information, but is not necessarily required to do so.

There are also active RFID transponders known which comprise a battery. Although most examples presented herein refer to passive transponders, the principle of the invention is applicable to semi passive, semi active or active transponders in an analogous way.

The usage of an RFID transponder can, for example, be described as follows. The RFID-reader transmits a radio signal of a certain frequency which is modulated by a "read ID command". The RFID-transponder, which is within range of the transmitted radio signal, which allows the transponder to gain enough energy from the radio signal to energize the RFID transponder, is thereby activated. For bidirectional communication, also the signal quality of the received radio signal needs to be good enough to identify the command or data transmitted by the RFID-reader. Alternatively, there are also known embodiments where the powering radio signal does not contain information and the transponder just responds to the powering signal.

The response of the transponder is either another radio signal, modulated according to the requested or a predefined information from the transponder, which is transmitted by the same or another aerial as used for receiving and/or energizing or the signal received is modulated by varying the load of the transponder. The radio signal transmitted or load modulated by the RFID transponder will be received by the RFID-Reader and its information content can be provided for further processing.

The transponder-electronics may be embodied as a discrete electronic circuit, but most common are single integrated circuits, which can be used as a die-only piece of silicon (with sizes down to 0.05 x 0.05 mm) or encapsulated in a standard integrated circuit package, which may be mounted on a printed circuit board (PCB) or directly contacted to the antenna. Alternatively, the integrated circuit or the whole PCB can also be embodied as thin-film or thick-film circuit or as a printed organic circuit.

To get a functioning transponder, the electronic circuit has to be coupled to at least one antenna, which enables the transponder to receive and utilize incident electromagnetic, magnetic or electrical wave energy for power as well as for receiving and/or transmitting data-information. There are also some integrated circuits known which do comprise the antenna as well, whereby no external antenna will be needed but only minimal reading distances are achieved. Other designs comprise an antenna-structure on the PCB onto which the electronics are mounted. The PCB can, for example, also be a foil-type flexo-print. Also, wire-structures can be attached as antennas. In practice, the connection of the antenna to the electronics is often a critical part in case of mechanical or chemical stress.

For protection of the transponder which comprises the electronics and the antenna, a coating can be applied, for example by an integration into a plastic confinement, by injection moulding, by placing it inside a plastic cover, or between two pieces of a foil material.

Concerning the tagging of textile items with RFID-Systems, the following devices and configurations are known.

In European patent application EP 2 131 304, a method for determining an order of objects which are tagged by an RFID transponder and transported by a conveyor along a conveyor path is disclosed. Besides others, garments are also examples of such tagged objects in this document.

So-called "Smart Tags" are commonly used for the marking of garments. "Smart tags" are very thin transponders that are disposed on a film together with the HF antenna. This film can be further processed (e.g. rolled, etc.) like paper. In particular, it can be laminated between layers of paper and thus integrated into conventional paper labels or also integrated in so-called chip cards like banking cards or access cards. Due to widespread use made possible by mass production, prices of such tags based on a HF antenna are very low.

The textile item tags or laundry tags as described above, however, are hardly suited to fulfil requirements of a laundry-cleaning-process, as they are imposed by laundry processes on a professional scale, including washing, drying, or ironing processes. A particular example is the de-watering process in industrial type laundries, for which heavy-duty centrifuges, generating accelerations up to 800 g, and high-power mechanical presses, exerting pressures higher than 50 bar, or air-drying-machinery at high temperatures of up to 300° Celsius are used. Common RFID-transponders are not designed to withstand such extreme processing conditions.

As the Garment tags have to withstand those laundry and dry cleaning conditions, RFID tags being at least partially designed to withstand such conditions are disclosed in the patent applications US 2005/01883990 and WO 2007/012810. U.S. patent No. 7,247,214 discloses a fabric label which preferably has a closed or essentially closed pocket, into which a marker, such as an RFID tag, is inserted. In one embodiment, the marker is inserted through a slit into the pocket, while in another embodiment, the marker is inserted into a closed pocket by a hollow needle which has penetrated through a wall of the pocket. It also addresses briefly the harsh conditions when RFID tags, attached to garments, are exposed to washing and dry cleaning conditions. However, in particular no specific embodiments to overcome the problems arising from this are disclosed.

For laundry processing, the capability to read-out whole carts or boxes filled with tagged laundry or batches of laundry on hangers or clamps closely aligned to one another, read-out distances of up to several meters (for example about 2 or 3 meters) would be advantageous, in particular in industrial laundry processing.

An object of the invention is to provide an improved RFID textile item tag, in particular optimized for professional laundry processes.

A particular object is to provide an RFID laundry tag with resistance against harsh external conditions such as high temperatures, high acceleration and high pressure.

A more particular object is to further provide a resistant RFID laundry tag for a read-out distance of up to several meters, at least in dry condition of the laundry.

A very special object is to provide a highly resistant RFID textile item tag which allows a simple and cost effective production and application of the textile item tag.

This task is solved by the subject matter of claim 1, i.e. by a textile item identification tag to be attached to a piece of laundry or garment with
• an encapsulated RFID transponder which is comprising an integrated circuit and at least one near-field antenna, which is electronically coupled to the integrated circuit,
• at least one far-field antenna positioned in inductive coupling condition with the at least one near-field antenna, and
• a pouch type enclosure for holding the RFID transponder.

Therein, the at least one far-field antenna comprises at least one curved section, which at least partially encloses a circumference of RFID transponder.

The textile item identification tag comprises a far field antenna for an RFID transponder. The RFID transponder comprises an integrated circuit and a near-field antenna. The far-field antenna is positioned to be in inductive coupling condition with the near-field antenna of the RFID transponder. The textile item tag also comprises a pouch type enclosure for receiving the RFID transponder and holding it in place. The textile item identification tag is designed to be attached to a piece of laundry or garment for allowing its identification.

To withstand the harsh laundry environments, a sufficient encapsulation of the transponder has to be ensured. This can be achieved by partially or fully enclosing the RFID transponder (comprising electronics and antenna) by materials like polyphenylene sulphide (PPS) so that water and chemicals used in laundry processing can not affect its function and also a protection against mechanical impacts can be assured.

Another advantage for withstanding the harsh conditions can be achieved by keeping the transponder small and thereby reduce the area for possible mechanical interactions and impacts like pressure, bending, folding, hitting, etc.

### RFID transponders for textile item tags as described above, can for example be coin-shaped

A disadvantage of a small size transponder is based on the fact that with the overall size, also the size of the antenna is decreased. As known in the art, a smaller antenna - in comparison to larger ones - in general has a reduced antenna gain or, in other words, a reduced capability for transmitting and receiving radio signals.

On the one hand, this can be overcome by an increase of the radio frequency used, as shorter wavelength in general requires smaller antenna structures. Therefore, the present invention is preferably related to UHF- or SHF-RFID transponders, although the underlying principles are applicable to other frequency ranges as well.

On the other hand, the connection of a large external far-field antenna would be a possible solution. For example, a loop or dipole antenna made from a wire which can be quite easily designed to meet the harsh environment of laundry processing, can be used. Such a far-field antenna can, for example, be applied by couching with a thread that comprises conductive materials, by soutache-application of a conductive material or by a sewing machine equipped with a braiding-foot. However, the electrical connection of such a far-field antenna to the circuit of the RFID transponder has to be considered as a weak point, which can easily be subject to ripping off, loosing contact or even breaking during laundry processing. An encapsulation of the whole antenna is not desirable, since this would result in an enlargement of the encapsulation, resulting in the rather mechanical problems already discussed above.

Another problem can be the quite difficult manufacturing process, needed to conductively connect a comparably large antenna to a comparably small transponder circuit, when fabricating a laundry identification tag, in particular when a proper connection of those two parts has to be guaranteed over a long lifetime of the textile item tag and many washing cycles.

The solution according to the present invention can overcome these concerns by a separate production of a small sized RFID transponder, for example encapsulated by a flat, coin shaped or pill-shaped, resistant enclosure made of sturdy polypropylene sulphide (PPS) material, which comprises transponder-electronics and a small sized near-field antenna, for example a loop- or chip-antenna.

PPS is a production material providing favourable properties: high chemical resistance, thermal stability, dimensional stability under harsh mechanical conditions like high pressure, fire resistance and high inertness against organic solvents, inorganic salts and bases. An RFID transponder, capable of withstanding the harsh conditions, can be produced in a standard mass-production environment, e.g. by injection moulding with PPS material. In addition, the resulting RFID transponder can also be used in many other - also non-laundry - applications which allow an advantageous increase of the production quantities.

However, the near field antenna, which is designed to fit within the enclosure of the RFID transponder, can in general not achieve the desired readout distances, since it is too small and a conductive path thorough the PPS-enclosure for connection of a far-field antenna is not desirable, as discussed above.

According to the invention, this aspect is overcome by a inductive mode coupling of an external far-field antenna to the internal near-field antenna of the RFID transponder, usually done by aligning parts of them in close distance to achieve an electromagnetic (in particular a dominantly magnetic) "crosstalk" among the two antennas.

In other words, the principle could also be described as a ("large") far-field antenna for communication with the RFID-reader, a section of which can be seen as a first near-field antenna. The RFID transponder comprises a second near-field antenna, conductively connected to the transponder electronics. According to the invention, the first and the second near-field antenna are designed and arranged to achieve an inductive coupling, whereby the RFID-electronics can make "indirect" use of the far-field antenna, without a conductive connection to it. Such inductive coupling is known to those skilled in the art.

In particular, the radio coupling can be achieved by arranging and shaping the far-field antenna and the near-field antenna in such a way that an inductive coupling section of the far-field antenna is aligned in or close to the inductive coupling range of a coupling section of the near-field antenna of the transponder.

The inductive coupling of the near-field antenna of the RFID transponder with a far-field antenna enables an extension of operation or read range for the laundry tag up to several meters, since the external far-field antenna can be much bigger sized than the internal antenna of the small RFID transponder, which results in an increased antenna-gain. The far-field antenna can, for example, be provided as a dipole antenna, or, alternatively, as another type of "flat" antenna previously mentioned.

The far-field antenna is comprised in, or attached to, the textile item tag. This can be done by various methods such as couching, embroidering, sewing, soutache, weaving or stitching of a yarn or wire comprising a conductive material as well as gluing, adhesive bonding, printing of conductive materials, insertion or application of a metal foil, etc.

The kind of attachment of the far-field antenna to the textile item tag can further effect at least a supporting functionality for keeping the RFID transponder in place and maintaining constant and well-defined conditions for the coupling of the near-field antenna of the RFID transponder to the far-field antenna of the tag.

In order to ensure a good coupling, it is one possible solution that the far-field antenna encircles the near-field antenna at least partially. To achieve this, the far-field antenna comprises a loop-shaped section, and the RFID transponder is at least partially surrounded by said loop-shaped section. This not only can achieve a sufficient coupling between the far-field and the near-field antenna, but can also improve the mechanical fixation of the RFID transponder to its holding means. As known in the art of antenna design, different embodiments of antennas will have different transmission characteristics which have to be considered when designing the antennas for decent coupling results.

For combining the far-field antenna and the RFID transponder, the textile item tag which comprises the far-field antenna can have a pouch-type enclosure (e.g. a strip, sachet or pocket, etc.) for receiving the RFID transponder which is designed and aligned to ensure the radio coupling of the antennas. The RFID transponder can be fixed in the pouch by closing it, for example by stitching, sewing, embroidering, filling it with glue or PPS-Material, glueing, moulding, thermo-patching or ultrasonic-welding.

The pouch can be formed out of the textile item tag material itself, as well as by application of another material, e.g. textile. For combining the RFID transponder and the textile item tag holding it in the pouch, for example the usage of flexible materials is one possible solution as well as a direct application using one of the methods for fixation described above like sewing, gluing, etc.. In particular a complete enclosure of the RFID transponder and possibly also the far-field antenna, can help protecting it from environmental impacts.

This approach, according to the present invention, allows an easy combination of two separately manufactured (or pre-assembled) parts (RFID transponder, textile item tag with far field antenna) as a simple process, which can take place e.g. as two stand alone products later combined during production of the garment or when the garment is prepared for the laundry process. Thereby, also the problem of how to fix a small-sized RFID transponder to the laundry or garment is solved. For example, the RFID transponder can just be slipped into a pouch type enclosure of the textile item tag. The transponder can additionally be fixed in the pouch by closing its entry e.g. by gluing, stitching, etc. If the pouch is made of flexible material and properly designed, the transponder can just be plunged into the pouch and does not necessarily need to be additionally fixed inside of it.

In particular, when using the antenna as fixation-means for the RFID transponder, the textile item tag already comprising the RFID transponder can also be pre-assembled to its final state before attaching it to the garment or laundry.

Subject of the invention is also a special RFID transponder for tagging laundry or garments, the RFID transponder comprising one near-field antenna designed for operation in a UHF frequency range and a second near-field antenna designed for operation in a HF frequency range. Thereby, the first near-field antenna is designed in such a way that it can be coupled to a far-field antenna. Using this setup, the tag can be used with HF and with UHF readers.

The textile item tag according to the invention is described or explained in more detail below, purely by way of example, with reference to working examples shown schematically in the drawings. Specifically,
Fig. 1 illustrates a first embodiment of an RFID transponder, for a textile item tag according to the invention;
Fig. 2 shows a second RFID transponder for a textile item tag according to the invention, which differs from the transponder of Fig. 1 in that the integrated circuit is further coupled to a second antenna;
Fig. 3a depicts an RFID transponder inserted into a sachet with a stitched opening as a first example for an embodiment of a textile item tag according to the invention;
Fig. 3b shows a three dimensional view of a second example for an embodiment of an RFID transponder inserted into a pouch of a textile item tag according to the invention;
Fig. 4a, 4b and 4c are illustrating a third, fourth and fifth example of embodiments of the textile item identification tags according to the invention;
Fig. 5 illustrates a first example of laundry or garment being equipped with a washing-note as an embodiment of a textile item tag according to the invention;
Fig. 6 illustrates a second example of laundry or garment being equipped with a brand label for a pair of trousers as an embodiment of a textile item tag according to the invention;
Fig. 7 illustrates a third example of laundry or garment being equipped with a button and button facing of a shirt or blouse as an embodiment of a textile item tag according to the invention;
Fig. 8 illustrates a fourth example of a T-shirt as a textile item or garment which is equipped with two embodiments of a textile item tag according to the invention comprised in the collar and hemline of the T-shirt.

In the following, the invention is described with reference to the figures. Equal reference numbers indicate equal system components or components used for equivalent functionality.

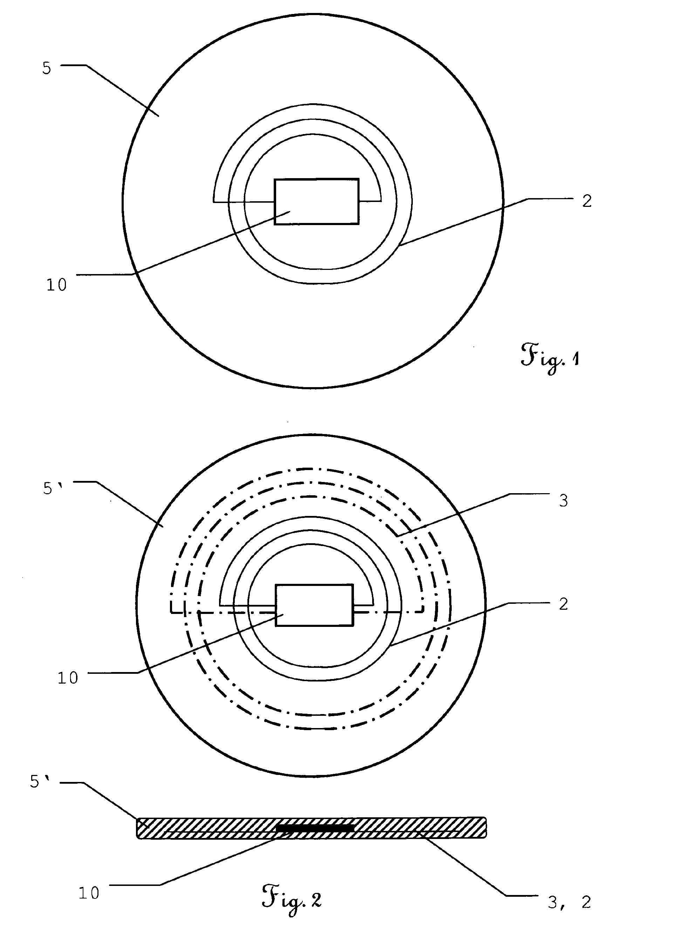

Fig. 1 illustrates a first embodiment of an RFID transponder 5 as it is known in the art. The RFID transponder 5 comprises an integrated circuit 10 which is electronically coupled to a near-field antenna 2 provided in the shape of a coil around the integrated circuit 10. The near-field antenna 2 may be operable in the HF, UHF and/or SHF frequency range. It is emphasized that the depicted geometrical shapes have only exemplary purpose. Different shapes, in particular of the antenna, like rectangles, squares etc. which serve the same purposes are included in the scope of the invention. The size of such an RFID transponder suitable for laundry processing is usually below about 20 mm in diameter and 3 mm in thickness, in particular below about 15 mm in diameter and 2 mm in thickness, or more particularly even less, like 10 mm in diameter and 1 mm in thickness.

In preferred embodiments of the method according to the invention, communication between the RFID reader and the RFID transponder is performed on frequencies of the UHF or SHF frequency range.

When referring to a circumference of the RFID transponder (5, 5'), in particular the circumference of the RFID transponder is meant, which is at least approximately on the same plane as the near-field antenna of the RFID transponder - or, more particularly on the plane with the best near-field coupling rate.

Fig. 2 shows a second exemplary embodiment of an RFID transponder 5' for a textile item tag according to the invention, which differs from the transponder 5 of the first embodiment in that the integrated circuit 10 is further coupled to a second near-field antenna 3. In this example, near-field antenna 2 is designed for operation in the HF range, and near-field antenna 3 for operation in the UHF range.

The lower part of the drawing illustrates a cut through the centre of the RFID transponder.

When using the RFID transponder, initially an RFID reader antenna directs an electromagnetic, magnetic or electrical field towards the transponder. After being energized, the transponder device sends back the identification information - usually a kind of digital code - to the reader, thus enabling identification of the transponder and, consequently, the object carrying the transponder. In this way, objects tagged with an RFID transponder can be identified and recognized individually.

The received identification may be displayed on a display device, stored on a storage medium, provided on an interface and/or processed for further use

In particular for the latter embodiment of the invention, it is preferred that the far-field antenna is designed in such a way that coupling with a near-field antenna operating in the UHF frequency range is enabled.

A near-field antenna for high frequency (HF) is designed to operate at frequencies between 3 MHz and 300 MHz, typically at 13.56 MHz. In contrast thereto, an antenna designed for operation in an ultra-high frequency (UHF) range typically operates between 860 MHz and 950 MHz, but also 2.45 GHz or even micro-wave frequency ranges around 5.8 GHz may be used as antennas for RFID applications. As mentioned, higher frequencies are in general associated with the advantage of smaller antenna dimensions and potential for increased data-rate.

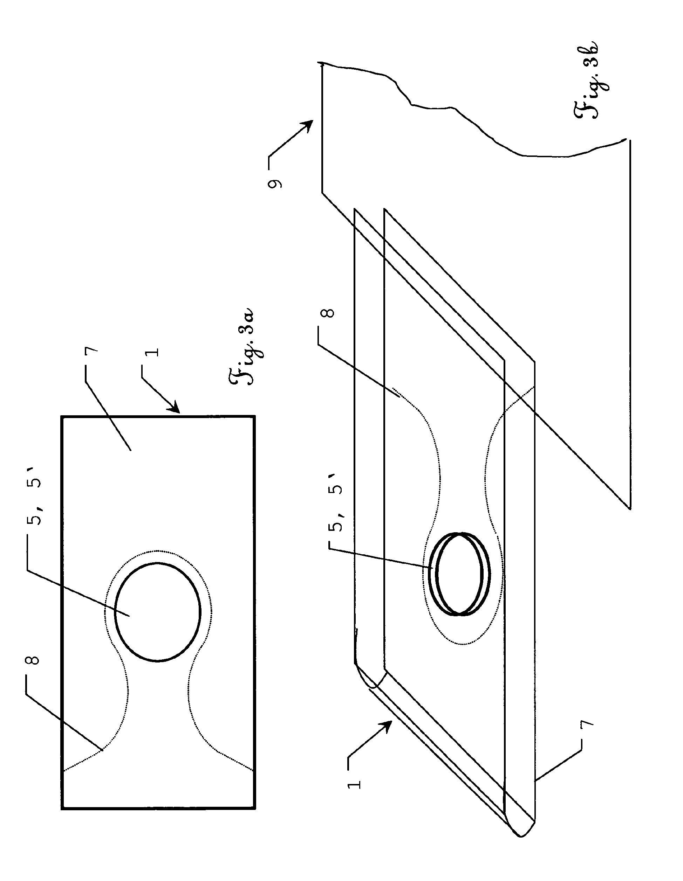

In Fig. 3a an RFID transponder 5 is depicted which is inserted into a sachet with a stitched opening 8 as an example for a textile item tag 1 made of flexible material for holding the transponder 5.

Fig. 3b illustrates a three dimensional view of a textile item tag comprising a pouch type enclosure formed by e.g. weaving, sewing, gluing along the line 8 as an example of a textile item tag 1 for comprising an RFID transponder 5 which can be inserted into the pouch. The tag 1 can then be attached to a piece of laundry or garment 9. The RFID transponder 5 is thereby surrounded by the sheet-like material 7 of which the tag is made.

The tag can be woven as a tube having one continuous, one-piece, seamless side panel or wall. Alternatively, the wall of the tag can be a folded web, heat-sealed, stitched, ultrasonically sealed, welded, adhesively bonded or otherwise attached along one side to provide a wall. The material of the fabric tag may, for example, be acetate, cotton, nylon, polyester and combinations thereof, in woven or non-woven form. The pouch can also be made of a different material than the textile item tag itself which is attached to the tag material. For example, an elastic piece of cloth can be stitched to a non-elastic textile item tag for forming the pouch.

The RFID transponder can be directly glued or welded into the tag material 7 or be held in place by closing the pouch by sewing or stitching or other means. It is also a possible embodiment to hold the tag in place by pocketing it into an elastic pouch that is shaped in such a way that an inserted transponder is fixated by the elastic material and will not slip out any more.

For ease of illustration of the presented examples of such a pouch-type enclosure, the far-field antenna, which is comprised by the textile item tag, is not drawn in Fig 3a and 3b, although it is, nevertheless, present according to the invention.

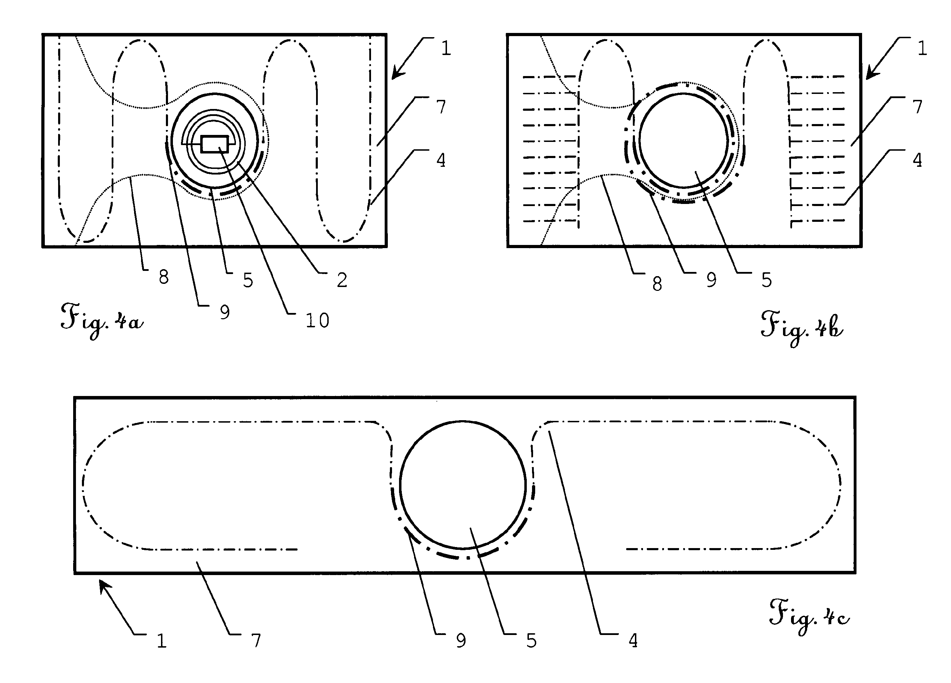

Fig. 4a, 4b and 4c show a third, fourth and fifth embodiment of a textile item tag 1 according to the invention, where the far field antenna 4 which is applied to or comprised by the textile item tag is explicitly depicted.

Fig. 4a shows the same textile item tag 1 with an RFID transponder 5 inserted into the pouch or sachet, similar to the one of Fig. 3a. In the embodiment of Fig. 4a which illustrates an embodiment of a textile item identification tag according to the invention, the far-field antenna 4 is stitched onto the sachet, and the antenna 4 is provided with a loop-shaped section 9 (indicated by a bold line).

The RFID transponder is placed partially surrounded by the loop-shaped section 9, resulting in a coupling between the far-field antenna 4 and the at least one near-field antenna 2, 3 comprised in the RFID transponder 5.

Additionally, this particular arrangement of the RFID transponder 5 in the loop-shaped section 9 of the far-field antenna 4 improves the fixation of the RFID transponder 5 to the textile item tag 1 by closing the open end of the pouch.

The RFID transponder 5, inserted into a pouch with a stitched opening 8 is shown in Fig. 4a and Fig 4b. In Fig. 4c the transponder is glued in-between the pouch made of two sheets of the tag-material 7. Also, three different shapes of tags and antennas are shown, whereas a person skilled in the art of RFID and/or antenna design will be able to adopt the shape and alignment of the far field antenna and/or the RFID transponder, as this is a routine task in these fields of the art.

As a particular embodiment, the pouch of Fig. 4a is closed by applying (e.g. sewing or embroidering with a thread comprising a conductive material) the far-field antenna, whereby the RFID transponder is also held in place.

In all three embodiments, section 9 of the far-field antenna can be seen, which at least partially encloses the RFID transponder 5. This partial surrounding of the near-field patch antenna of the RFID transponder by the far-field dipole antenna of the textile item tag is a preferred embodiment of the inductive coupling of those two antennas according to the invention.

Again, as for all the exemplary embodiments, a person skilled in the art of designing antennas will be capable of designing many other geometrical shapes of one or both of the antennas resulting in a coupling.

In a particular embodiment, the textile item tag according to the invention can be a stand alone piece of cloth (e.g. a textile, such as acetate, cotton, nylon, polyester and combinations thereof, in woven or non-woven form) a foil or another sheet-like, flexible material which can be attached to the garment or has already been attached during the production of the garment.

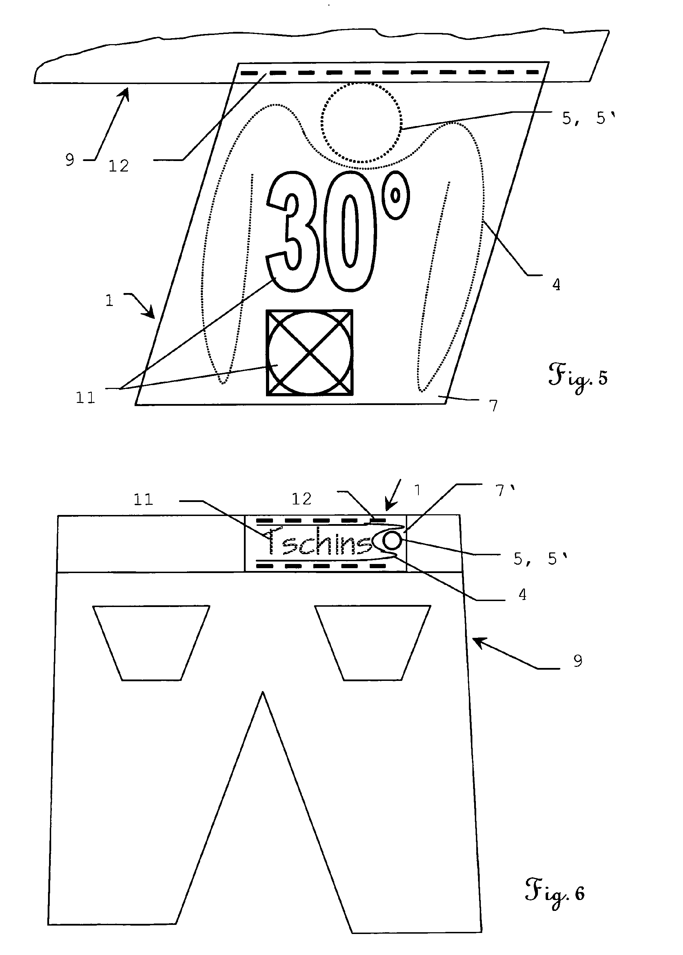

Furthermore, the textile item tag can also be used as e.g. a washing note or slip as shown in Fig. 5, where a well known washing tag 1, comprising product information - in this example washing instructions 11 - is shown, which is applied to a piece of linen 9 by sewing 12. Again, the washing tag 1 comprises a far-field antenna 4 and a pouch type enclosure. In advance of applying the washing note 1 to the laundry 9, the RFID transponder 5 has been inserted or applied to the tag 1.

The term textile item tag or laundry tag - as used in the present application - is not restricted to those classical textile item or laundry tags, containing writings, laundry symbols, sizes or the like. Since the laundry tags of the present application are designed to be, at least primarily, RFID tags, they are not restricted to the classical embodiments of such tags. They can even be almost invisibly integrated into the piece of laundry or garment, not noticeable by human beings.

Therefore, in an advanced embodiment, the washing note does not even need to comprise the literal washing instructions, as those can advantageously also be stored on the RFID transponder, e.g. allowing the usage of the slip for other purposes. Also, the marking of the clothes size could be stored, although it is likely that an, at least additional, literal mentioning of the size on the tag would be preferred by the customers.

Fig. 6 shows a similar example, wherein the textile item tag according to the invention is embodied as a branding label 1 for trousers 9 which is applied by stitching 12. The far-field antenna of the branding label according to the invention comprises the far field antenna 4, in this particular example embodied as an accordingly shaped piece of metal foil laminated into the label material 7'. The RFID transponder 5 can also be laminated into to the label or be applied later on by gluing it in, by ultrasonic welding or other known techniques.

Also, sewing the label to the garment with conductive thread, to be used as far-field antenna, could be a possible solution.

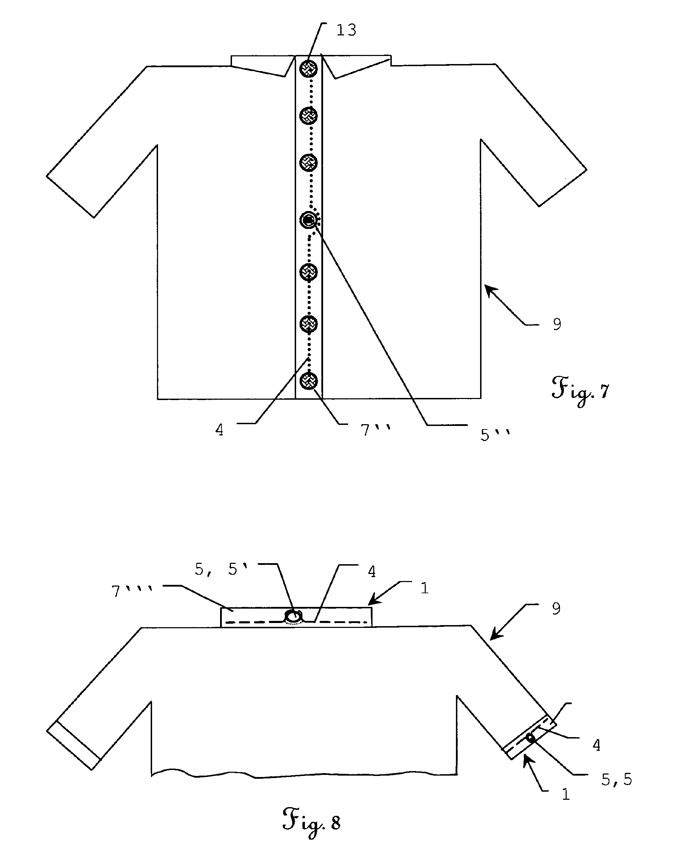

Fig 7. shows a third example of a garment equipped with a special embodiment of a laundry tag according to the invention. The illustrated solution comprises an RFID transponder 5" as button of the garment and a button facing 7" comprises the far-field antenna 4. In this embodiment, the textile item tag 1 is an integral part of the garment itself. One of the buttons 13 is or comprises the RFID transponder and a part of the shirt itself is the textile item tag, comprising the far-field antenna, e.g. as a piece of conductive thread comprised in the cloth of the shirt, like the button facing or buttonhole, which is aligned in a coupling position with the RFID-transponder-button. A button-like transponder, for example can be fixed as an ordinary button.

Fig 8. shows a fourth, very special example of a piece of garment with an embodiment of a textile item tag according to the invention, wherein the laundry tag 1 is embodied as a collar or a hemline of a T-shirt 9. In this figure, two examples of different possibilities for placement are shown.

## Claims

1. A textile item identification tag (1) to be attached to a piece of laundry or garment (9) with
- an encapsulated RFID transponder (5, 5') which comprises an integrated circuit (10) and at least one near-field antenna (2, 3), which is electronically coupled to the integrated circuit (10),
- at least one far-field antenna (4) positioned in coupling condition with the at least one near-field antenna (2, 3), and
- a pouch-type enclosure (8) for holding the RFID transponder (5, 5'),
**characterized in that**
the at least one far-field antenna (4) comprises at least one curved section (9), which at least partially encloses a circumference of the RFID transponder (5, 5').

2. The textile item identification tag (1) according to claim 1,
**characterized in that**
the RFID transponder (5, 5') is enclosed by said at least one curved section (9) to an extent of at least half of the circumference, in particular to an extent of at least two-thirds of the circumference, more particularly completely enclosed by said at least one curved section (9).

3. The textile item identification tag (1) according to any one of the preceding claims,
**characterized in that**
the at least one far-field antenna (4) has at least one further curved section.

4. The textile item identification tag (1) according to any one of the preceding claims,
**characterized in that**
the encapsulated RFID transponder (5, 5') is completely sealed off from the environment, in particular by an encapsulation made partially or entirely of PPS material.

5. The textile item identification tag (1) according to any one of the preceding claims,
**characterized in that**
the RFID transponder (5, 5') operates in the UHF or SHF frequency range.

6. The textile item identification tag (1) according to any one of the preceding claims,
**characterized in that**
the textile item identification tag (1) is implemented as a piece of cloth or foil to be attached to a piece of laundry or garment (9), in particular a washing-note, slip, label, collar or hemline.

7. The textile item identification tag (1) according to any one of the preceding claims,
**characterized in that**
the pouch type enclosure (8) is shaped to firmly hold the RFID transponder (5) in place with respect to the far-field antenna (4) by a tight mechanically fit of the pouch (8) and the transponder (5).

8. The textile item identification tag (1) according to any one of the preceding claims,
**characterized in that**
the pouch type enclosure (8) and/or the textile item tag (1) is made of flexible material.

9. The textile item identification tag (1) according to any one of the preceding claims 1 to 7,
**characterized in that**
the far-field antenna (4) is applied by stitching a thread comprising conductive material, in particular wherein the applied far-field antenna closes an open end of the pouch.

10. The textile item identification tag (1) according to any one of the preceding claims 1 to 7,
**characterized in that**
the far-field antenna (4) is applied by printing conductive material or applying a conductive polymerizable liquid to the textile item tag (1) or pouch (8) material.

11. The textile item identification tag (1) according to any one of the preceding claims 1 to 7,
**characterized in that**
the far-field antenna (4) is applied by gluing, laminating or thermo-patching a conductive foil material to the pouch (8) or textile item tag (1) material.

12. The textile item identification tag (1) according to any one of the preceding claims 1 to 7,
**characterized in that**
the pouch type enclosure (8) comprises the far-field antenna (4) integrated into the pouch (8) material, in particular wherein the far-field antenna (4) is applied to the textile item tag (1) material by weaving of conductive material.

13. The textile item identification tag (1) according to any one of the preceding claims,
**characterized in that**
the far-field antenna (4) is arranged on the inner side of the pouch-type enclosure (8).

14. The textile item identification tag (1) according to any one of the preceding claims,
**characterized in that**
the at least one far-field antenna (4) is a dipole-antenna and the at least one near-field antenna (2, 3) is a loop-antenna, in particular wherein the far-field antenna (4) and the near-field antenna (2, 3) are arranged and shaped in such a way that the curved section (9) of the far-field antenna (4) resides, at least partially, in inductive coupling range to a portion of the near-field antenna (2, 3) of the transponder.

15. Production method for a textile item identification tag (1) according to claim 1 by the steps of:
- providing a pre-assembled, encapsulated RFID transponder (5), which comprises
an integrated circuit (10) and
at least one first antenna (2, 3) which is electronically coupled to the integrated circuit;
- providing a textile item tag (1) comprising a pouch type enclosure (8) for enclosing the RFID transponder (5) and
at least one second antenna (4), which at least partially encloses a circumference of the pouch (8) for the RFID-transponder (5) by at least one curved section (9) of the second antenna (4) in such a way to radio-couple the second antenna (4) with the first antenna (2, 3) of an enclosed RFID transponder (5);
- inserting the RFID transponder (5) into the pouch type enclosure (8);
- fixing the RFID transponder (5) in the pouch (8).

## Patentansprüche

1. Identifizierungszeichen für ein Textilelement (1), das an einem Wäsche- oder Kleidungsstück (9) zu befestigen ist, mit
- einem verkapselten RFID-Transponder (5, 5'), der einen integrierten Schaltkreis (10) und mindestens eine Nahfeldantenne (2, 3) umfasst, die mit dem integrierten Schaltkreis (10) elektronisch verbunden ist,
- mindestens einer Fernfeldantenne (4), die in Kopplungsbedingung mit der mindestens einen Nahfeldantenne (2, 3) positioniert ist, und
- einem beutelartigen Behältnis (8) zur Aufnahme des RFID-Transponders (5, 5'),
**dadurch gekennzeichnet, dass**
die mindestens eine Fernfeldantenne (4) mindestens einen gebogenen Abschnitt (9) umfasst, der zumindest teilweise einen Außenumfang des RFID-Transponders (5, 5') einschließt.

2. Identifizierungszeichen für ein Textilelement (1) gemäß Anspruch 1,
**dadurch gekennzeichnet, dass**
der RFID-Transponder (5, 5') von dem mindestens einen gebogenen Abschnitt (9) in einem Ausmaß von mindestens der Hälfte des Außenumfangs eingeschlossen ist, insbesondere in einem Ausmaß von mindestens zwei Dritteln des Außenumfangs und im besonderen gänzlich von dem mindestens einen gebogenen Abschnitt (9) eingeschlossen ist.

3. Identifizierungszeichen für ein Textilelement (1) gemäß einem der vorangehenden Ansprüche,
**dadurch gekennzeichnet, dass**
die mindestens eine Fernfeldantenne (4) mindestens einen weiteren gebogenen Abschnitt umfasst.

4. Identifizierungszeichen für ein Textilelement (1) gemäß einem der vorangehenden Ansprüche,
**dadurch gekennzeichnet, dass**
der verkapselte RFID-Transponder (5, 5') von der Umgebung vollständig abgeschlossen ist, insbesondere durch eine Verkapselung, die teilweise oder vollständig aus PPS-Material gefertigt ist.

5. Identifizierungszeichen für ein Textilelement (1) gemäß einem der vorangehenden Ansprüche,
**dadurch gekennzeichnet, dass**
der RFID-Transponder (5, 5') im UHF- oder SHF-Frequenzband betrieben wird.

6. Identifizierungszeichen für ein Textilelement (1) gemäß einem der vorangehenden Ansprüche,
**dadurch gekennzeichnet, dass**
das Identifizierungszeichen für ein Textilelement (1) als ein Stück Stoff oder Folie ausgeführt ist, das an einem Stück Wäsche oder Kleidung (9) zu befestigen ist, insbesondere als Waschzettel, Slip, Etikett, Kragen oder Saum.

7. Identifizierungszeichen für ein Textilelement (1) gemäß einem der vorangehenden Ansprüche,
**dadurch gekennzeichnet, dass**
das beutelartige Behältnis (8) so geformt ist, dass es den RFID-Transponder (5) mit Bezug auf die Fernfeldantenne (4) mittels einer engen mechanischen Anpassung von Beutel (8) und Transponder (5) fest hält.

8. Identifizierungszeichen für ein Textilelement (1) gemäß einem der vorangehenden Ansprüche,
**dadurch gekennzeichnet, dass**
das beutelartige Behältnis (8) und/oder das Textilelementzeichen (1) aus flexiblem Material gefertigt ist.

9. Identifizierungszeichen für ein Textilelement (1) gemäß einem der vorangehenden Ansprüche 1 bis 7,
**dadurch gekennzeichnet, dass**
die Fernfeldantenne (4) durch Aufsticken mit einem ein leitendes Material enthaltenden Faden angebracht wird, wobei die aufgebrachte Fernfeldantenne insbesondere ein offenes Ende des Beutels schließt.

10. Identifizierungszeichen für ein Textilelement (1) gemäß einem der vorangehenden Ansprüche 1 bis 7,
**dadurch gekennzeichnet, dass**
die Fernfeldantenne (4) durch Aufdrucken von leitendem Material oder Aufbringen einer leitenden, polymerisierbaren Flüssigkeit auf das Material des Textilelementzeichens (1) oder des Beutels (8) angebracht wird.

11. Identifizierungszeichen für ein Textilelement (1) gemäß einem der vorangehenden Ansprüche 1 bis 7,
**dadurch gekennzeichnet, dass**
die Fernfeldantenne (4) durch Kleben, Laminieren oder Thermo-Patchen eines leitenden Folienmaterials auf das Material des Beutels (8) oder des Textilelementzeichens (1) aufgebracht wird.

12. Identifizierungszeichen für ein Textilelement (1) gemäß einem der vorangehenden Ansprüche 1 bis 7,
**dadurch gekennzeichnet, dass**
das beutelartige Behältnis (8) die Fernfeldantenne (4) in das Material des Beutels (8) integriert umfasst, insbesondere wenn die Fernfeldantenne (4) auf das Material des Textilelementzeichens (1) durch Einweben von leitendem Material aufgebracht wird.

13. Identifizierungszeichen für ein Textilelement (1) gemäß einem der vorangehenden Ansprüche,
**dadurch gekennzeichnet, dass**
die Fernfeldantenne (4) an der Innenseite des beutelartigen Behältnisses (8) angeordnet ist.

14. Identifizierungszeichen für ein Textilelement (1) gemäß einem der vorangehenden Ansprüche,
**dadurch gekennzeichnet, dass**
die mindestens eine Fernfeldantenne (4) eine Dipolantenne und die mindestens eine Nahfeldantenne (2, 3) eine Peilantenne ist, wobei die Fernfeldantenne (4) und die Nahfeldantenne (2, 3) insbesondere derart angeordnet und geformt sind, dass sich der gebogene Abschnitt (9) der Fernfeldantenne (4) zumindest teilweise in induktiver Kopplungsreichweite zu einem Abschnitt der Nahfeldantenne (2, 3) des Transponders befindet.

15. Produktionsverfahren für ein Identifizierungszeichen für ein Textilelement (1) gemäß Anspruch 1 in folgenden Schritten:
- Bereitstellen eines vormontierten, verkapselten RFID-Transponders (5), der einen integrierten Schaltkreis (10) und mindestens eine erste Antenne (2, 3) umfasst, die mit dem integrierten Schaltkreis elektronisch gekoppelt ist;
- Bereitstellen eines Textilelementzeichens (1), das ein beutelartiges Behältnis (8) zum Umschließen des RFID-Transponders (5) hat, und
mindestens einer zweiten Antenne (4), die einen Außenumfang des Beutels (8) für den RFID-Transponder (5) mit mindestens einem gebogenen Abschnitt (9) der zweiten Antenne (4) zumindest teilweise so umschließt, dass die zweite Antenne (4) an die erste Antenne (2, 3) eines umschlossenen RFID-Transponders (5) funkgekoppelt ist;
- Einsetzen des RFID-Transponders (5) in das beutelartige Behältnis (8);
- Befestigen des RFID-Transponders (5) im Beutel (8).

## Revendications

1. Etiquette d'identification d'article textile (1) à fixer à un morceau de linge ou de vêtement (9) dotée
- d'un répondeur d'identification par radiofréquences (répondeur d'identification RFID) encapsulé (5, 5') lequel comprend un circuit intégré (10) et au moins une antenne à champ proche (2, 3), laquelle est électroniquement couplée au circuit intégré (10),
- d'au moins une antenne à champ lointain (4) positionnée dans une condition de couplage avec la au moins une antenne à champ proche (2, 3), et
- une enceinte de type sachet (8) destinée à maintenir le répondeur d'identification RFID (5, 5'),
**caractérisée en ce que**
la au moins une antenne à champ lointain (4) comprend au moins une partie incurvée (9), laquelle enferme au moins partiellement une circonférence du répondeur d'identification RFID (5, 5').

2. Etiquette d'identification d'article textile (1) selon la revendication 1,
**caractérisée en ce que**
le répondeur d'identification RFID (5, 5') est enfermé par ladite au moins une partie incurvée (9) sur une étendue couvrant au moins la moitié de la circonférence, en particulier sur une étendue couvrant au moins les deux tiers de la circonférence, plus particulièrement totalement enfermé par ladite au moins une partie incurvée (9).

3. Etiquette d'identification d'article textile (1) selon l'une quelconque des revendications précédentes,
**caractérisée en ce que**
la au moins une antenne à champ lointain (4) présente au moins une autre partie incurvée.

4. Etiquette d'identification d'article textile (1) selon l'une quelconque des revendications précédentes,
**caractérisée en ce que**
le répondeur d'identification RFID encapsulé (5, 5') est totalement hermétique à l'environnement, en particulier grâce à une encapsulation partiellement ou entièrement constituée d'un matériau de PPS.

5. Etiquette d'identification d'article textile (1) selon l'une quelconque des revendications précédentes,
**caractérisée en ce que**
le répondeur d'identification RFID (5, 5') fonctionne dans la plage des ultra-hautes fréquences (UHF) ou des supra-hautes fréquences (SHF).

6. Etiquette d'identification d'article textile (1) selon l'une quelconque des revendications précédentes,
**caractérisée en ce que**
l'étiquette d'identification d'article textile (1) est mise en oeuvre sous la forme d'un morceau de tissu ou de feuille à fixer à un morceau de linge ou de vêtement (9), en particulier sur une étiquette de lavage, un bout de papier, une étiquette, un col ou un ourlet.

7. Etiquette d'identification d'article textile (1) selon l'une quelconque des revendications précédentes,
**caractérisée en ce que**
l'enceinte de type sachet (8) est dimensionnée pour maintenir fermement le répondeur d'identification RFID (5) en place par rapport à l'antenne à champ lointain (4) par un ajustage mécaniquement serré du sachet (8) et du répondeur d'identification (5).

8. Etiquette d'identification d'article textile (1) selon l'une quelconque des revendications précédentes,
**caractérisée en ce que**
l'enceinte de type sachet (8) et/ou l'étiquette d'article textile (1) sont constituées d'un matériau souple.

9. Etiquette d'identification d'article textile (1) selon l'une quelconque des revendications précédentes 1 à 7,
**caractérisée en ce que**
l'antenne à champ lointain (4) est appliquée par couture d'un fil comprenant un matériau conducteur, en particulier où l'antenne à champ lointain appliquée enferme une extrémité ouverte du sachet.

10. Etiquette d'identification d'article textile (1) selon l'une quelconque des revendications précédentes 1 à 7,
**caractérisée en ce que**
l'antenne à champ lointain (4) est appliquée par impression d'un matériau conducteur ou par application d'un liquide polymérisable conducteur sur l'étiquette d'article textile (1) ou sur le matériau du sachet (8).

11. Etiquette d'identification d'article textile (1) selon l'une quelconque des revendications précédentes 1 à 7,
**caractérisée en ce que**
l'antenne à champ lointain (4) est appliquée par collage, laminage ou retouche thermique d'un matériau en feuille conducteur sur le sachet (8) ou sur le matériau de l'étiquette d'article textile (1).

12. Etiquette d'identification d'article textile (1) selon l'une quelconque des revendications précédentes 1 à 7,
**caractérisée en ce que**
l'enceinte de type sachet (8) comprend l'antenne à champ lointain (4) intégrée dans le matériau du sachet (8), en particulier où l'antenne à champ lointain (4) est appliquée sur le matériau de l'étiquette d'article textile (1) par tissage d'un matériau conducteur.

13. Etiquette d'identification d'article textile (1) selon l'une quelconque des revendications précédentes,
**caractérisée en ce que**
l'antenne à champ lointain (4) est disposée sur le côté interne de l'enceinte de type sachet (8).

14. Etiquette d'identification d'article textile (1) selon l'une quelconque des revendications précédentes,
**caractérisée en ce que**
la au moins une antenne à champ lointain (4) est une antenne dipôle et la au moins une antenne à champ proche (2, 3) est antenne cadre, en particulier où l'antenne à champ lointain (4) et l'antenne à champ proche (2, 3) sont disposées et dimensionnées de telle sorte que la partie incurvée (9) de l'antenne à champ lointain (4) réside, au moins partiellement, selon une portée de couplage inductif jusqu'à une zone de l'antenne à champ proche (2, 3) du répondeur d'identification.

15. Procédé de fabrication d'une étiquette d'identification d'article textile (1) selon la revendication 1, grâce aux étapes :
- de fourniture d'un répondeur d'identification RFID encapsulé pré-assemblé (5), lequel comprend un circuit intégré (10) et au moins une première antenne (2, 3) laquelle est électroniquement couplée au circuit intégré ;
- de fourniture d'une étiquette d'article textile (1) comprenant une enceinte de type sachet (8) destinée à enfermer le répondeur d'identification RFID (5) et
au moins une deuxième antenne (4), laquelle enferme au moins partiellement une circonférence du sachet (8) destiné au répondeur d'identification (5) grâce à au moins une partie incurvée (9) de la deuxième antenne (4) de sorte à coupler en fréquences la deuxième antenne (4) à la première antenne (2, 3) d'un répondeur d'identification RFID enfermé (5) ;
- d'insertion du répondeur d'identification RFID (5) dans l'enceinte de type sachet (8) ;
- de fixation du répondeur d'identification RFID (5) dans le sachet (8).
